(19) Europäisches Patentamt / European Patent Office / Office européen des brevets

(11) **EP 4 439 976 A1**

(12) **DEMANDE DE BREVET EUROPEEN**

(43) Date de publication:
**02.10.2024 Bulletin 2024/40**

(21) Numéro de dépôt: **24165579.4**

(22) Date de dépôt: **22.03.2024**

(51) Classification Internationale des Brevets (IPC):
**H03D 7/14** *(2006.01)*     **H04B 7/005** *(2006.01)*
**H03F 3/189** *(2006.01)*     **H03F 3/24** *(2006.01)*

(52) Classification Coopérative des Brevets (CPC):
**H03D 7/14; H04B 7/005;** H03F 3/189; H03F 3/24

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **31.03.2023 FR 2303142**

(71) Demandeur: **STMicroelectronics International N.V.**
**1228 Plan-les-Ouates, Geneva (CH)**

(72) Inventeurs:
• **TU, Cao-Thong**
**1003 Lausanne (CH)**
• **COUSINARD, David**
**1110 Morges (CH)**
• **CHAMPION, David**
**1297 Founex (CH)**
• **CONTALDO, Matteo**
**1022 Chavannes-Pres-Renens (CH)**

(74) Mandataire: **Cabinet Beaumont**
**4, Place Robert Schuman**
**B.P. 1529**
**38025 Grenoble Cedex 1 (FR)**

(54) **DÉCALAGE FRÉQUENTIEL D'UN SIGNAL D'HORLOGE**

(57) La présente description concerne un dispositif électronique (200) configuré pour appliquer une fonction de décalage fréquentiel à un premier signal (Clk_F) ayant une première fréquence (F) comprenant :
- un élément à retard (206) adapté à fournir un deuxième signal (Clk_F_D) correspondant au premier signal retardé d'une durée égale à une première période dudit premier signal (Clk_F) divisée par quatre ;
- une branche comprenant successivement un premier circuit (201) adapté à diviser la fréquence d'un signal par un nombre, un deuxième circuit intégrateur (203), ladite branche étant adaptée à fournir un troisième signal (Q_comp) et un quatrième signal (I_comp) ; et
un troisième circuit mélangeur à bande latérale unique (208).

**Fig. 2**

EP 4 439 976 A1

**Description**

Domaine technique

La présente description concerne de façon générale la transmission radiofréquence de données, et le traitement de signaux. La présente description se rapporte plus particulièrement à la réalisation d'une fonction de décalage fréquentiel d'un signal généré par un oscillateur local, c'est-à-dire un signal d'horloge.

Technique antérieure

Les techniques d'analyse et de traitement de signaux sont utilisées de nos jours pour optimiser la transmission de données.

Il serait souhaitable de pouvoir améliorer, au moins en partie, certains aspects du traitement et de la transmission de signaux.

Résumé de l'invention

Il existe un besoin pour une transmission de données plus performante.

Il existe un besoin pour une transmission d'un signal plus performante.

Il existe un besoin pour une mise en oeuvre d'une fonction de décalage fréquentiel d'un signal d'horloge plus performante.

Un mode de réalisation pallie tout ou partie des inconvénients des chaînes de transmission de données connus.

Un mode de réalisation pallie tout ou partie des inconvénients des dispositifs connus mettant en oeuvre une opération de décalage fréquentiel d'un signal d'horloge.

Un mode de réalisation prévoit un dispositif électronique configuré pour appliquer une fonction de décalage fréquentiel à un premier signal ayant une première fréquence comprenant :

- un élément à retard adapté à fournir un deuxième signal correspondant au premier signal retardé d'une durée égale à une première période dudit premier signal divisée par quatre ;

- une branche comprenant successivement un premier circuit adapté à diviser la fréquence d'un signal par un nombre, un deuxième circuit intégrateur, ladite branche étant adaptée à fournir un troisième signal et un quatrième signal ; et

un troisième circuit mélangeur à bande latérale unique adapté à combiner le premier signal, le deuxième signal, et le troisième signal et le quatrième signal pour fournir un cinquième signal.

Selon un mode de réalisation, ledit premier circuit est adapté à fournir un sixième signal correspondant à la quadrature du premier signal dont la fréquence est divisée par ledit nombre,
le troisième signal étant obtenu en fournissant le sixième signal audit deuxième circuit intégrateur.

Selon un mode de réalisation, ledit premier circuit est adapté à fournir, en outre, un septième signal correspondant au premier signal dont la fréquence est divisée par ledit nombre, et
ladite branche comprenant, en outre, un quatrième circuit intégrateur adapté à recevoir le sixième signal et à fournir le quatrième signal.

Selon un mode de réalisation, le dispositif comprend, en outre, un cinquième circuit de changement de signe adapté à modifier le signe dudit deuxième signal pour fournir un huitième signal.

Selon un mode de réalisation, le cinquième signal est donné par la formule mathématique suivante :

$$Mix\_F\_offset(t) = Clk\_F(t) * I\_comp(t) + Clk\_F\_Q(t) * Q\_comp(t)$$

dans laquelle :

- Mix_F_offset(t) représente le cinquième signal ;
- Clk_F(t) représente le premier signal ;
- I_comp(t) représente le quatrième signal ;
- Clk_F_Q(t) représente le huitième signal ; et
- Q_comp(t) représente le troisième signal.

Selon un mode de réalisation, ledit cinquième circuit de changement de signe est commandable.

Selon un mode de réalisation, le nombre est un multiple de deux.

Selon un mode de réalisation, le nombre est un multiple de quatre.

Selon un mode de réalisation, ledit élément de retard est un élément à retard programmable.

Selon un mode de réalisation, le premier signal est un signal d'horloge.

Un autre mode de réalisation prévoit une chaîne de transmission d'un signal comprenant un dispositif décrit précédemment.

Selon un mode de réalisation, la chaîne comprend, en outre :

- un générateur de fréquence ;
- un modulateur sur fréquence porteuse ; et
- un circuit amplificateur de puissance.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, très schématiquement et sous forme de blocs, un mode de réalisation d'une partie d'une chaîne de transmission de données ;

la figure 2 représente, très schématiquement et sous forme de blocs, un mode de réalisation d'un dispositif mettant en oeuvre une opération de décalage fréquentiel d'un signal d'horloge ;

la figure 3 représente des chronogrammes illustrant le fonctionnement du mode de réalisation de la figure 2 ;

la figure 4 est un graphique illustrant un exemple d'une fonction de compression utilisée dans le mode de réalisation de la figure 2 ;

la figure 5 représente un autre chronogramme illustrant le fonctionnement du mode de réalisation de la figure 2 ; et

la figure 6 représente encore un autre chronogramme illustrant le fonctionnement du mode de réalisation de la figure 2.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

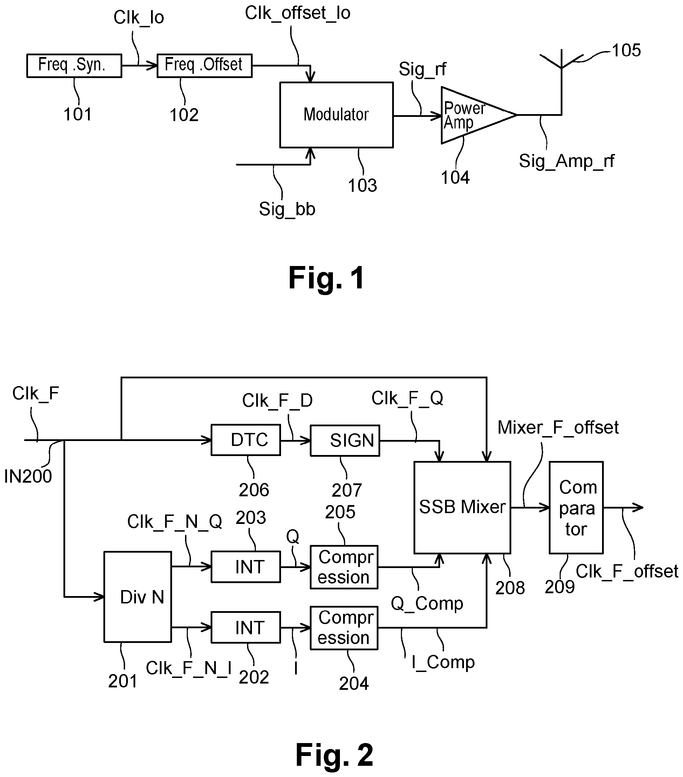

La figure 1 représente, très schématiquement et sous forme de blocs, un mode de réalisation d'une partie 100 d'une chaîne de transmission radiofréquence de données. Autrement dit, la figure 1 représente un mode de réalisation d'une partie d'une chaîne de transmission adaptée à transmettre des données utilisant des signaux dont la fréquence est comprise entre 3 kHz et 300GHz.

La partie 100 de la chaîne de transmission comprend :

- un circuit générateur de fréquence 101 (Freq Syn) ;
- un mode de réalisation d'un dispositif 102 (Freq Offset) adapté à mettre en oeuvre une fonction de décalage fréquentiel d'un signal d'horloge reçu en entrée ;

- un modulateur sur fréquence porteuse 103 (Modulator) ;
- un circuit amplificateur de puissance 104 (Power Amp) ; et
- une antenne 105.

Le circuit générateur de fréquence 101, ou synthétiseur de fréquence (Frequency Synthesizer), est un circuit adapté à générer un signal d'horloge, c'est-à-dire un signal à fréquence constante, de préférence un signal carré à fréquence constante, aussi appelé signal créneau à fréquence constante. Selon un exemple, le circuit générateur de fréquence est un oscillateur local. Selon un exemple, le circuit 101 est une boucle à verrouillage de phase (Phase-Locked Loop, PLL). Ainsi, en figure 1, le circuit 101 fournit, en sortie, un signal d'horloge Clk_lo périodique de type carré ayant une fréquence F_lo constante.

Il est convenu, dans la suite de la description, qu'un signal d'horloge de fréquence F désigne un signal périodique carré de période 1/F. Dans la suite, les signaux dont la référence commence par Clk sont des signaux d'horloge. De plus, un signal d'horloge Clk(t) idéal de fréquence F est donné par la formule mathématique suivante :

$$\mathrm{Clk}(t) = \mathrm{sign}\big(sin(2\pi F t + \phi_0)\big)$$

dans laquelle $\phi_0$ désigne la phase initiale, et la fonction mathématique sign est donnée par la formule mathématique suivante :

$$\mathrm{sign(x)} = \begin{cases} 1 \; si \; x \geq 0 \\ -1 \; sinon \end{cases}$$

Le dispositif 102 met en oeuvre une fonction de décalage fréquentiel (Frequency Offset) du signal d'horloge Clk_lo qu'il reçoit en entrée. Ainsi, le dispositif 102 reçoit, en entrée le signal d'horloge Clk_lo de fréquence F_lo, et fournit en sortie un signal d'horloge Clk_offset_lo de type carré ayant une fréquence F_offset_lo. Un mode de réalisation du dispositif 102 est décrit plus en détail avec la figure 2.

Le signal d'horloge Clk_offset_lo est obtenu par un mélange fréquentiel à bande latérale unique (Single Side Band Mixing, SSB Mixing) du signal d'horloge Clk_lo avec un signal correspondant au signal d'horloge Clk_lo dont la fréquence F a été divisée par un entier N. Ainsi, la fréquence F_offset_lo du signal d'horloge Clk_offset_lo est donnée par la formule mathématique suivante :

$$\mathrm{F\_offset\_lo} = F\_lo + \mathrm{sign\_offset}\left(\frac{\mathrm{F\_lo}}{N}\right)$$

dans laquelle la fonction sign_offset est une fonction signe commandable qui est égale à 1 ou à -1.

Le modulateur sur fréquence porteuse 103 (Modulator) reçoit en entrée un signal de données Sig_bb et le signal d'horloge Clk_offset_lo, et fournit, en sortie, un signal modulé de sortie Sig_rf. Le signal Sig_bb est le signal à transmettre comprenant, par exemple, des données, ce signal est aussi appelé signal en bande de base. Le signal d'horloge Clk_offset_lo est utilisé comme signal porteur. Autrement dit, la fréquence F_offset_lo est la fréquence porteuse du signal modulé Sig_bb.

Selon une variante, le signal d'horloge Clk_offset_lo peut subir une éventuelle division fréquentielle par un entier K avant de servir de signal porteur. Dans ce cas-là, la fréquence porteuse du signal modulé Sig_rf est égale à la fréquence F_offset_lo divisée par l'entier K.

Le circuit amplificateur de puissance 104 reçoit, en entrée, le signal modulé Sig_rf, et fournit, en sortie, un signal modulé amplifié Sig_amp_rf. Le circuit amplificateur 104 peut, dans certaines architectures, engendrer un phénomène de couplage avec le circuit générateur de fréquence 101. L'utilisation du dispositif 102 permet d'éviter ce phénomène en évitant que les harmoniques du signal Sig_rf dont les fréquences sont des multiples entiers de la fréquence F_rf du signal Sig_rf ne coïncident avec le signal d'horloge Clk_lo de fréquence F_lo.

L'antenne 105 reçoit le signal modulé amplifié Sig_amp_rf et le transmet.

La figure 2 représente, schématiquement et sous forme de blocs, un mode de réalisation d'un dispositif 200 adapté à appliquer une fonction de décalage fréquentiel du type du dispositif 102 décrit en relation avec la figure 1.

Le dispositif 200 comprend un noeud d'entrée IN200 adapté à recevoir un signal d'horloge Clk_F de fréquence F.

Le dispositif 200 comprend une branche comportant, dans l'ordre suivant :

- un circuit diviseur de fréquence 201 (DIV N) ;

- deux circuits intégrateur 202 (INT) et 203 (INT) ; et
- deux circuits 204 (COMP) et 205 (COMP), optionnels, adaptés à appliquer une fonction de compression.

Le circuit diviseur de fréquence 201 reçoit, en entrée, le signal d'horloge Clk_F et fournit en sortie deux signaux Clk_F_N_I et Clk_F_N_Q. Le signal d'horloge Clk_F_N_I correspond au signal Clk_F dont la fréquence a été divisée par un entier N, que l'on note par la suite F_N. Le signal d'horloge Clk_F_N_Q correspond à la quadrature du signal d'horloge Clk_F_N_I. En pratique, le signal d'horloge Clk_F_N_Q est une version retardée d'une durée Tau_N du signal Clk_F_N_I. Le signal d'horloge Clk_F_N_Q(t) est donnée par la formule mathématique suivante :

$$Clk\_F\_N\_Q(t) = Clk\_F\_N\_I(t - Tau\_N)$$

Pour permettre une quadrature parfaite entre les signaux d'horloge Clk_F_N_I et Clk_F_N_Q, le décalage temporel Tau_N est donnée par la formule mathématique suivante :

$$Tau\_N = \frac{N * T}{4}$$

dans laquelle T est la période du signal Clk_F, c'est-à-dire l'inverse de la fréquence F.

La valeur de l'entier N peut être commandable. Selon un mode de réalisation, l'entier N est un multiple de deux. Selon un mode de réalisation préféré, l'entier N est un multiple de quatre. La durée Tau_N correspond, dans ce cas, alors à un nombre entier de périodes T.

Le circuit intégrateur 202 reçoit, en entrée, le signal d'horloge Clk_F_N_I, et fournit en sortie un signal analogique I. Le signal I est obtenu en intégrant, dans le domaine temporel, le signal d'horloge Clk_F_N_I. Ainsi, en pratique, comme le signal d'horloge Clk_F_N_I est un signal carré de fréquence F_N, le signal I est un signal triangulaire de fréquence F_N.

Le circuit intégrateur 203 reçoit, en entrée, le signal d'horloge Clk_F_N_Q, et fournit en sortie un signal analogique Q. Le signal Q est obtenu en intégrant, dans le domaine temporel, le signal d'horloge Clk_F_N_Q. Ainsi, en théorie, comme le signal d'horloge Clk_F_N_Q est une version décalée de la durée Tau_N du signal d'horloge Clk_F_N_I, le signal Q est une version retardée de la durée Tau_N du signal I. Autrement dit, le signal Q(t) est donné par la formule mathématique suivante :

$$Q(t) = I(t - Tau\_N)$$

Le circuit 204 adapté à appliquer, de manière optionnelle, une fonction de compression, dans le domaine temporel, reçoit, en entrée, le signal I, et fournit en sortie un signal I_comp. Une fonction de compression bien choisie, ce choix est à la portée de la personne du métier, permet de fournir en sorte un signal se rapprochant d'un signal sinusoïdal. Le signal I_comp(t) est donné par la formule mathématique suivante :

$$I\_comp(t) = Gcomp\big(I(t)\big)$$

dans laquelle Gcomp est la fonction de compression.

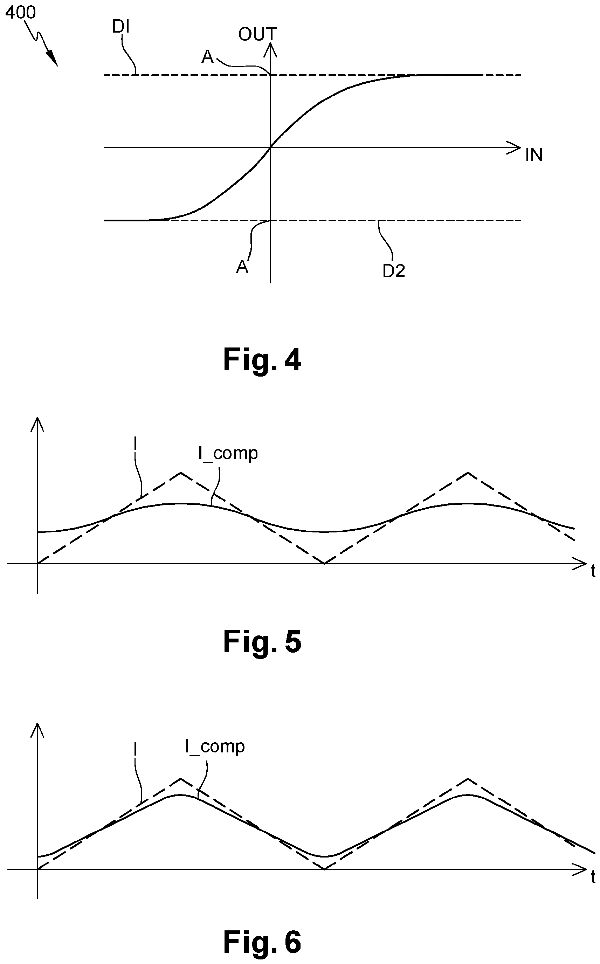

Un exemple d'une fonction de compression mise en oeuvre par les circuits 204 et 205 est décrite en relation avec la figure 4.

Le circuit 205 est identique au circuit 204, optionnel et est adapté à appliquer la fonction de compression Gcomp décrite précédemment. Le circuit 205 reçoit, en entrée, le signal Q, et fournit en sortie un signal Q_comp. En théorie, comme le signal Q est une version retardée de la durée Tau_N du signal I, le signal Q_comp est donc une version retardée de la durée Tau_N du signal I_comp. Autrement dit, le signal Q_comp(t) est donné par la formule mathématique suivante :

$$Q\_comp(t) = I\_comp(t - Tau\_N)$$

Le dispositif 102 comprend, en outre, un élément de retard 206 (DTC) adapté à décaler temporellement un signal d'une durée Tau. L'élément de retard reçoit, en entrée, le signal d'horloge Clk_F et fournit en sortie un signal d'horloge décalé temporellement Clk_F_D. Ainsi, le signal d'horloge Clk_F_D(t) est donnée par la formule mathématique suivante :

$$Clk\_F\_D(t) = Clk\_F(t - Tau)$$

Selon un mode de réalisation, la durée Tau est donnée par la formule mathématique suivante :

$$Tau = \frac{T}{4}$$

De plus, et selon un mode de réalisation, l'élément de retard 206 est configurable. En particulier, la durée Tau est configurable, ce qui permet au dispositif 102 de s'adapter à n'importe quelle fréquence d'entrée F.

Le dispositif 102 comprend, en outre et de manière optionnelle, un circuit de changement de signe 207 (SIGN). Le circuit de changement de signe 207 permet de définir l'opération réalisée par la fonction sign_offset décrite précédemment. Plus particulièrement, le circuit 207 permet de déterminer si la fréquence du signal de sortie du dispositif 200 est égale à la somme ou à la différence des fréquences F et F_N. Selon un exemple, si le dispositif 200 fournit en sortie un signal dont la fréquence est le résultat d'une différence, dans ce cas la fonction sign_offset est égale à moins un, le circuit de changement de signe n'est pas présent. Selon un exemple, si le dispositif 200 fournit en sortie un signal dont la fréquence est le résultat d'une somme, dans ce cas la fonction sign_offset est égale à un, le circuit de changement de signe permet d'inverser le signe du signal qu'il reçoit. Selon un autre exemple, le circuit 207 peut être un circuit commandable permettant, à partir d'un signal de commande, d'inverser ou non le signe du signal d'horloge qu'il reçoit ou non.

Ainsi, le circuit de changement de signe 207 reçoit, en entrée, le signal d'horloge Clk_F_D, et fournit en sortie un signal d'horloge Clk_F_Q. Le signal Clk_F_Q correspond au signal d'horloge Clk_F dont le signe a été inversé ou non. Le signal Clk_F_Q(t) est donné par la formule mathématique suivante :

$$Clk\_F\_Q(t) = -sign\_offset * Clk\_F\_D(t)$$

Le dispositif 102 comprend, en outre, un circuit de mélangeur à bande latérale unique 208 (SSB Mixer), qui est utilisé pour moduler les signaux analogiques en quadrature I_comp et Q_comp par les signaux d'horloge Clk_F et Clk_F_Q, en fournissant en sortie le signal Mix_F_offset. En théorie, le mélangeur à bande latérale unique réalise l'opération décrite par l'équation mathématique suivante :

$$Mix\_F\_offset(t) = Clk\_F(t) * I\_comp(t) + Clk\_F\_Q(t) * Q\_comp(t)$$

Selon une variante, les fonctions de compression de circuits 204 et 205 sont directement mise en oeuvre par le circuit 208.

Le signal Mix_F_offset obtenu en sortie est, par construction, un signal analogique périodique de fréquence F_N. Mais, la plus grande partie de la puissance de ce signal se retrouve concentrée dans l'harmonique du signal Mix_F_offset de fréquence F_offset, donnée par l'équation suivante :

$$F\_offset = F + sign\_offset * \frac{F}{N}$$

Le dispositif 102 comprend, enfin un dispositif de régénération d'horloge 209, qui, à partir du signal analogique en entrée Mix_F_offset, fournit le signal d'horloge Clk_F_offset, en effectuant une comparaison par rapport à zéro. Le signal Clk_F_offset(t) est donné par la formule mathématique suivante :

$$Clk\_F\_offset(t) = sign\big(Mix\_F\_offset(t)\big)$$

De manière optionnelle, le circuit 209 de régénération du signal d'horloge intègre un filtre avant la comparaison à zéro afin d'améliorer la pureté spectrale du signal d'horloge Clk_F_offset. Dans ce cas, le signal Clk_F_offset(t) est donné par la formule mathématique suivante :

$$\text{Clk\_F\_offset}(t) = \text{sign}\big(\text{h}(t) \otimes \text{Mix\_F\_offset}(t)\big)$$

dans laquelle h(t) est la réponse impulsionnelle du filtre.

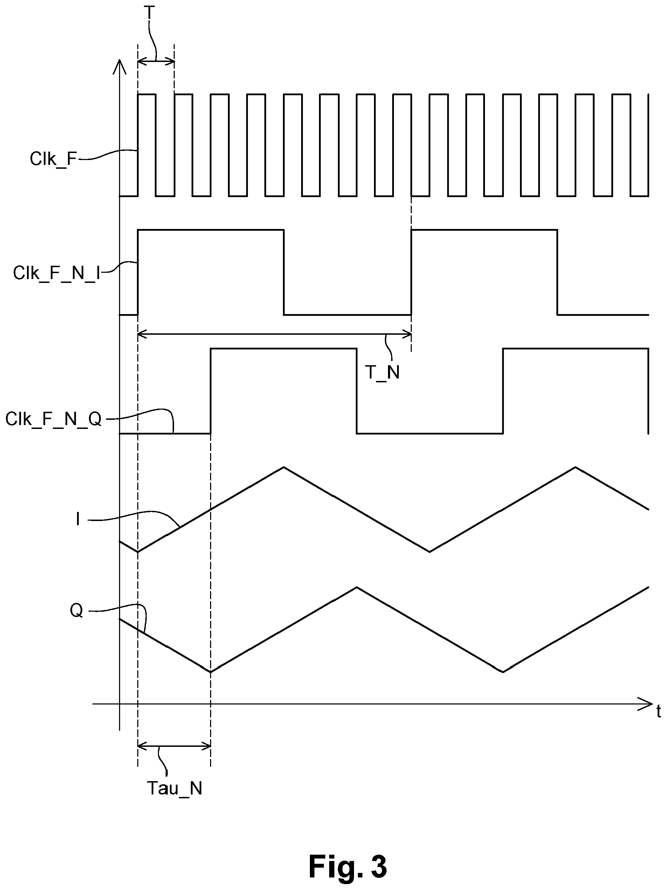

Le fonctionnement du dispositif 200 est illustré plus en détail en relation avec les chronogrammes des figures 3 et 5 et avec le graphique de la figure 4.

La figure 3 comprend des chronogrammes illustrant un exemple pratique de fonctionnement du dispositif 200 décrit en relation avec la figure 2.

La figure 3 comprend les chronogrammes suivants :

- un chronogramme référencé Clk_F représentant l'évolution temporelle du signal d'horloge Clk_F décrit en relation avec la figure 2 ;
- un chronogramme référencé Clk_F_N_I représentant l'évolution temporelle du signal d'horloge Clk_F_N_I décrit en relation avec la figure 2 ;
- un chronogramme référencé Clk_F_N_Q représentant l'évolution temporelle du signal d'horloge Clk_F_N_Q décrit en relation avec la figure 2 ;
- un chronogramme référencé I représentant l'évolution temporelle du signal I décrit en relation avec la figure 2 ; et
- un chronogramme référencé Q représentant l'évolution temporelle du signal Q décrit en relation avec la figure 2.

Comme dit précédemment, le signal d'horloge Clk_F est un signal d'horloge de fréquence F et de période T.

Les signaux d'horloge Clk_F_N_I et Clk_F_N_Q sont également des signaux périodiques carrés. Cependant, comme les signaux d'horloge Clk_F_N_I et Clk_F_N_Q sont les signaux de sortie du circuit 201, leur fréquence est la fréquence F_N, et leur période est une durée T_N égale à la période T multipliée par l'entier N. En figure 3, l'entier N est égal à huit. Le signal d'horloge Clk_F_N_Q est décalé temporellement par rapport au signal d'horloge Clk_F_N_I du décalage temporel Tau_N décrit précédemment.

Les signaux I et Q sont des signaux périodiques triangulaires. Cependant, comme les signaux I et Q sont obtenus en intégrant les signaux d'horloge Clk_F_N_I et Clk_F_N_Q, leur fréquence est la fréquence F_N, et leur période est une durée T_N. Le signal Q est décalé temporellement par rapport au signal I du décalage temporel Tau_N décrit précédemment.

La figure 4 est un graphique 400 illustrant l'évolution d'une fonction Gcomp de compression appliquée par les circuits 204 et 205 décrits en relation avec la figure 2.

L'axe des abscisses du graphique 400 représente la valeur de l'amplitude du signal d'entrée, et l'axe des ordonnées représente l'amplitude du signal d'entrée transformé par la fonction Gcomp.

Selon un exemple, la fonction Gcomp est une fonction du type tangente hyperbolique.

La figure 5 comprend deux chronogrammes illustrant un exemple pratique de fonctionnement du dispositif 200 décrit en relation avec la figure 2.

La figure 5 comprend les chronogrammes suivants :

- le chronogramme référencé I, en trait pointillé, représentant l'évolution temporelle du signal I décrit en relation avec la figure 2 ; et
- un chronogramme référencé I_comp représentant l'évolution temporelle du signal I_comp décrit en relation avec la figure 2.

Comme décrit précédemment, le signal I est un signal périodique de forme triangulaire.

Le signal I_comp correspond à l'application de la fonction de compression du circuit 204 au signal I. Comme dit précédemment, le signal I_comp est un signal dont la forme est pseudo-sinusoïdale et a une fréquence égale à la fréquence F_N.

De la même façon, le signal I_comp, non représenté, a une forme pseudo-sinusoïdale, a une fréquence égale à la fréquence F_N, et a un décalage temporel égal à la durée Tau_N par rapport au signal I_comp.

La figure 6 comprend deux chronogrammes illustrant un autre exemple pratique de fonctionnement du dispositif 200 décrit en relation avec la figure 2.

Comme la figure 5, la figure 6 comprend les chronogrammes suivants :

- le chronogramme référencé I, en trait pointillé, représentant l'évolution temporelle du signal I décrit en relation avec la figure 2 ; et
- un chronogramme référencé I_comp représentant l'évolution temporelle du signal I_comp décrit en relation avec la figure 2.

Comme décrit précédemment, le signal I est un signal périodique de forme triangulaire.

Le signal I_comp correspond à l'application de la fonction de compression du circuit 204 au signal I. Comme dit précédemment, le signal I_comp est un signal dont la forme est pseudo-sinusoïdale et a une fréquence égale à la fréquence F_N.

De la même façon, le signal I_comp, non représenté, a une forme pseudo-sinusoïdale, a une fréquence égale à la fréquence F_N, et a un décalage temporel égal à la durée Tau_N par rapport au signal I_comp.

A la différence de la figure 5, en figure 6, le signal I_comp a une forme qui épouse plus la forme du signal triangulaire I.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

**Revendications**

1.  Dispositif électronique (102 ; 200) configuré pour appliquer une fonction de décalage fréquentiel à un premier signal (Clk_F_lo ; Clk_F) ayant une première fréquence (F_lo ; F) comprenant :

    - un élément à retard (206) adapté à fournir un deuxième signal (Clk_F_D) correspondant au premier signal retardé d'une durée (Tau) égale à une première période (T) dudit premier signal (Clk_F) divisée par quatre ;
    - une branche comprenant successivement un premier circuit (201) adapté à diviser la fréquence d'un signal par un nombre (N), un deuxième circuit intégrateur (203), ladite branche étant adaptée à fournir un troisième signal (Q_comp) et un quatrième signal (I_comp) ; et

    un troisième circuit mélangeur à bande latérale unique (208) adapté à combiner le premier signal (Clk_F), le deuxième signal (Clk_F_D), le troisième signal (Q_comp) et le quatrième signal (I_comp) pour fournir un cinquième signal (Mixer_F_offset).

2.  Dispositif selon la revendication 1, dans lequel ledit premier circuit (201) est adapté à fournir un sixième signal (Clk_F_N_Q) correspondant à la quadrature du premier signal (Clk_F) dont la fréquence (F) est divisée par ledit nombre (N),
    le troisième signal (Q_comp) étant obtenu en fournissant le sixième signal (Clk_F_N_Q) audit deuxième circuit intégrateur (203).

3.  Dispositif selon la revendication 1 ou 2, dans lequel ledit premier circuit (201) est adapté à fournir, en outre, un septième signal (Clk_F_N_I) correspondant au premier signal (Clk_F) dont la fréquence (F) est divisée par ledit nombre (N), et
    ladite branche comprenant, en outre, un quatrième circuit intégrateur (202) adapté à recevoir le sixième signal (Clk_F_N_I) et à fournir le quatrième signal (I_comp).

4.  Dispositif selon l'une quelconque des revendications 1 à 3, comprenant, en outre, un cinquième circuit de changement de signe (206) adapté à modifier le signe dudit deuxième signal (Clk_F_D) pour fournir un huitième signal (Clk_F_Q).

5.  Dispositif selon la revendication 4, dans lequel le cinquième signal (Mixer_F_offset) est donné par la formule mathématique suivante :

$$Mix\_F\_offset(t) = Clk\_F(t) * I\_comp(t) + Clk\_F\_Q(t) * Q\_comp(t)$$

dans laquelle :

    - Mix_F_offset(t) représente le cinquième signal (Mix_F_offset) ;
    - Clk_F(t) représente le premier signal (Clk_F) ;
    - I_comp(t) représente le quatrième signal (I_comp) ;
    - Clk_F_Q(t) représente le huitième signal (Clk_F_Q) ; et
    - Q_comp(t) représente le troisième signal (Q_comp).

**6.** Dispositif selon la revendication 4 ou 5, dans lequel ledit cinquième circuit de changement de signe (207) est commandable.

**7.** Dispositif selon l'une quelconque des revendications 1 à 6, dans lequel le nombre (N) est un multiple de deux.

**8.** Dispositif selon la revendication 7, dans lequel le nombre (N) est un multiple de quatre.

**9.** Dispositif selon l'une quelconque des revendications 1 à 8, dans lequel ledit élément de retard (201) est un élément à retard programmable.

**10.** Dispositif selon l'une quelconque des revendications 1 à 9, dans lequel le premier signal (Clk_F) est un signal d'horloge.

**11.** Chaîne de transmission (100) d'un signal comprenant un dispositif (102 ; 200) selon l'une quelconque des revendications 1 à 10.

**12.** Chaîne selon la revendication 11, comprenant, en outre :

- un générateur de fréquence (101) ;
- un modulateur sur fréquence porteuse (104) ; et
- un circuit amplificateur de puissance (105).

Clk_lo    Clk_offset_lo

Freq .Syn. → Freq .Offset → Modulator → Sig_rf → Power Amp → 105

101    102    103    104    Sig_Amp_rf

Sig_bb

## Fig. 1

Clk_F

Clk_F_D    Clk_F_Q    Mixer_F_offset

IN200    DTC → SIGN

206    207
205

Clk_F_N_Q    203    Q

Div N → INT → Compr ession → SSB Mixer → Com para tor →

208    209    Clk_F_offset

INT → Compr ession

Q_Comp

201    Clk_F_N_I    202    I    204    I_Comp

## Fig. 2

**Fig. 3**

**Fig. 4**

**Fig. 5**

**Fig. 6**

Europäisches
Patentamt

European
Patent Office

Office européen
des brevets

# RAPPORT DE RECHERCHE EUROPEENNE

Numéro de la demande

EP 24 16 5579

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 850 121 B1 (DETERING VOLKER [DE] ET AL) 1 février 2005 (2005-02-01) * colonne 1 - colonne 8; figures 1-13 * | 1-12 | INV. H03D7/14 H04B7/005 |
| X | US 2011/140760 A1 (KRIVOKAPIC IVAN [US] ET AL) 16 juin 2011 (2011-06-16) * alinéa [0003] - alinéa [0043]; figures 1-4 * | 1-12 | ADD. H03F3/189 H03F3/24 |
| A | US 2009/304044 A1 (VAN DE BEEK REMCO CORNELIS HERMAN [NL] ET AL) 10 décembre 2009 (2009-12-10) * alinéa [0001] - alinéa [0072]; figures 1-10 * | 1-12 | |
| A | Coates Eric: "Integrators", , 29 décembre 2020 (2020-12-29), pages 1-2, XP093090175, Extrait de l'Internet: URL:https://learnabout-electronics.org/ac_theory/filters85.php#:~:text=Integration%20of%20a%20Square%20Wave&text=The%20integrator%20has%20converted%20the,moving%20from%20left%20to%20right). [extrait le 2023-10-10] * le document en entier * | 1-12 | DOMAINES TECHNIQUES RECHERCHES (IPC) H03D H04B |

Le présent rapport a été établi pour toutes les revendications

| Lieu de la recherche | Date d'achèvement de la recherche | Examinateur |
|---|---|---|
| La Haye | 3 juin 2024 | Rafflenbeul, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 24 16 5579

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-06-2024

| Document brevet cité au rapport de recherche | | Date de publication | Membre(s) de la famille de brevet(s) | | Date de publication |
|---|---|---|---|---|---|
| US 6850121 | B1 | 01-02-2005 | CA | 2377790 A1 | 04-01-2001 |
| | | | CN | 1370347 A | 18-09-2002 |
| | | | DE | 19928998 A1 | 02-08-2001 |
| | | | EP | 1188228 A1 | 20-03-2002 |
| | | | ES | 2220483 T3 | 16-12-2004 |
| | | | HK | 1048713 A1 | 11-04-2003 |
| | | | JP | 2003503930 A | 28-01-2003 |
| | | | KR | 20020016838 A | 06-03-2002 |
| | | | US | 6850121 B1 | 01-02-2005 |
| | | | WO | 0101562 A1 | 04-01-2001 |
| US 2011140760 | A1 | 16-06-2011 | EP | 1775843 A1 | 18-04-2007 |
| | | | US | 2007081610 A1 | 12-04-2007 |
| | | | US | 2011140760 A1 | 16-06-2011 |
| US 2009304044 | A1 | 10-12-2009 | CN | 101103550 A | 09-01-2008 |
| | | | EP | 1842294 A1 | 10-10-2007 |
| | | | JP | 2008527886 A | 24-07-2008 |
| | | | US | 2009304044 A1 | 10-12-2009 |
| | | | WO | 2006075288 A1 | 20-07-2006 |

EPO FORM P0460

Pour tout renseignement concernant cette annexe : voir Journal Officiel de l'Office européen des brevets, No.12/82